# FASCICULE DE BREVET EUROPEEN

(11) **EP 0 463 693 B1**
(45) Date de publication et mention de la délivrance du brevet: **11.01.1995**
(21) Numéro de dépôt: 91201560.9
(22) Date de dépôt: 19.06.1991
(51) Int. Cl.: H05K 3/00

(54) **Appareil et système de poinçonnage de circuits imprimés**
Vorrichtung und System zum Stanzen von gedruckten Schaltplatten
Apparatus and system for punching printed circuit boards

(30) Priorité: 26.06.1990 FR 9007994
(43) Date de publication de la demande: 02.01.1992
(73) Titulaire: PHILIPS CIRCUITS IMPRIMES, 27016 Evreux (FR); Philips Electronics N.V., 5621 BA Eindhoven (NL)
(72) Inventeur: Philippe, Michel, Société Civile S.P.I.D., F-75008 Paris (FR); Sorel, Alain, Société Civile S.P.I.D., F-75008 Paris (FR)
(74) Mandataire: Caron, Jean

(56) Documents cités:
- FR-A- 2 248 666
- GB-A- 2 179 884
- US-A- 4 824 310
- IBM TECHNICAL DISCLOSURE BULLETIN. vol. 33, no. 1B, Juin 1990, NEW YORK US, pages 419-420 "board flotation device for matrix drilling"
- IBM TECHNICAL DISCLOSURE BULLETIN, vol. 26, no. 10A, Mars 1984,NEW YORK US,pages 5100-5102;CONESKI ET AL: 'PUNCH PROGRAMMING MECHANISM'

## Description

La présente invention concerne un appareil de poinçonnage de circuits imprimés équipé d'une première partie d'outil à laquelle sont fixés une pièce porte-poinçons et un serre-flanc, et d'une seconde partie d'outil constituée essentiellement d'une matrice, l'appareil étant prévu pour introduire entre le serre-flanc et la matrice une plaque de circuit imprimé à poinçonner, appareil qui comporte des premiers moyens commandables pour appliquer une force sur le porte-poinçon dans la direction d'enfoncement des poinçons, et des deuxièmes moyens commandables indépendants des premiers pour appliquer une force sur le serre-flanc dans la direction qui appuie sur le circuit imprimé à poinçonner.

Un appareil de poinçonnage de circuits imprimés selon le préambule ci-dessus est connu de GB-A-2 179 884 (Hitachi). Avec l'appareil décrit dans ce document, le serre-flanc et le porte-poinçons sont appliqués sur la pièce à poinçonner au moyen de vérins mais la remontée du porte-poinçon est assurée par des ressorts (4). En outre pour la remontée du serre-flanc, celui-ci est tiré par le support du porte poinçons au moyen de tirants (10) : cette remontée ne peut donc pas être bien contrôlée.

L'invention se propose d'améliorer la qualité des trous ou orifices réalisés, c'est-à-dire entre autres leur précision géométrique. Elle a notamment pour but de fournir un appareil capable de concurrencer les appareils de perçage par forets sur le plan de la qualité des trous obtenus (au moins pour les trous de diamètre 0,7 mm et plus), tout en apportant la vitesse très supérieure du procédé par poinçonnage.

L'invention est notamment basée sur l'idée que la précision doit dépendre du bon contrôle des forces mises en jeu. Par exemple, avec les ressorts de l'art antérieur, les forces mises en jeu sont difficiles à contrôler.

Ainsi, l'appareil selon l'invention est remarquable en ce que les premiers moyens comportent un actionneur commandable pour appliquer une force sur le porte-poinçon dans la direction d'extraction des poinçons, et en ce que des troisièmes moyens commandables sont prévus qui, prenant appui d'une part sur le porte- poinçons et d'autre part sur le serre-flanc, les écartent l'un de l'autre.

Par le mot "moyen commandable", on entend par exemple un ou plusieurs jeux de vérins hydrauliques, ou bien un moteur électrique, ou un électro-aimant, etc, à l'exclusion par contre d'un ressort qui applique une force que l'on ne peut commander c'est-à-dire faire varier à volonté sans déplacer de pièce.

Les troisièmes moyens permettent de mieux contrôler les forces en jeu pendant la remontée des poinçons.

Dans une forme de réalisation particulière de l'appareil, au moins une des deux parties d'outil est montée flottante, et le serre-flanc et la matrice sont munis de moyens de positionnement relatif l'un par rapport à l'autre et par rapport au circuit imprimé.

En positionnant ainsi directement l'un par rapport à l'autre le circuit imprimé et le porte-poinçon ainsi que la matrice, on obtient une bien meilleure précision du poinçonnage, même si les tolérances pour le montage des différents éléments de l'appareil sont par ailleurs moins serrées.

Pour améliorer encore la précision du travail de coupe, les points d'application de la force des deuxièmes moyens étant situés près des bords du serre-flanc et du porte-poinçons, ces derniers sont précontraints c'est-à-dire qu'ils ont, au repos, une forme convexe avec la convexité tournée vers le circuit imprimé.

Toujours pour améliorer la précision, l'appareil est avantageusement muni de moyens pour réaliser deux cycles de descente/remontée successifs des poinçons avec la même configuration de poinçonnage et sur une même plaque de circuit imprimé, et de moyens pour maintenir tout en la modifiant entre les deux cycles la force exercée par le deuxième moyen commandable.

Ceci permet une détente du matériau du circuit imprimé (par diminution de la force exercée par le deuxième moyen commandable), grâce à laquelle ses dimensions se stabilisent, et après laquelle on répète un deuxième cycle de descente/remontée des poinçons.

L'appareil est avantageusement muni de moyens de chauffage de la matrice et/ou du serre-flanc. Les poinçons qui pénètrent dans des trous du serre-flanc sont donc chauffés par ce dernier. Le circuit imprimé pressé entre le serre-flanc et la matrice avant le déclenchement du cycle de poinçonnage est chauffé lui aussi. L'avantage du chauffage est de réduire la force nécessaire pour le poinçonnage, et donc d'améliorer la précision (qui décroît lorsque les forces nécessaires sont plus grandes).

Il est avantageux que la matrice soit recouverte d'une tôle dont les trous ont été poinçonnés par les poinçons de l'appareil eux mêmes. Ainsi les diamètres des trous de la matrice peuvent être plus grands et néanmoins la matière du circuit imprimé est bien soutenue à la périphérie du trou. En outre, la tôle peut être changée en cas d'usure, au lieu d'avoir à réaffûter le bord des trous de la matrice, opération beaucoup plus difficile.

Avec les machines décrites dans les documents cités plus haut, dont les poinçons sont munis d'une seule arête d'extrémité tranchante, le poinçonnage se fait à simple action, c'est-à-dire qu'un poinçon descend en réalisant un trou, puis remonte sans nouvel effet de coupe. Cela présente l'inconvénient d'exercer une contrainte dissymétrique sur les circuits imprimés, qui nuit à la précision géométrique des bords des trous réalisés.

Pour éviter cet inconvénient, les poinçons sont avantageusement munis d'une seconde arête tranchante qui est orientée en sens inverse de celle de la susdite extrémité tranchante et qui est destinée à couper au cours du mouvement de retrait du poinçon. Ladite seconde arête tranchante peut être constituée du fait que le poinçon porte une gorge dont un bord constitue cette arête.

Un système de poinçonnage de circuits imprimés est avantageusement constitué de plusieurs appareils selon l'invention, chacun d'eux poinçonnant une configuration de trous différente de celle des autres appareils. Ainsi, les dimensions de chaque appareil sont plus petites et la précision est encore améliorée. Notamment la dilatation dûe au chauffage de l'outil et de la plaque est limitée.

La description qui va suivre, en regard des dessins annexés décrivant des exemples non limitatifs fera bien comprendre comment l'invention peut être réalisée.

La figure 1 est une vue latérale schématique en coupe d'un appareil selon l'invention. Différentes parties de la coupe peuvent correspondre à des plans différents de l'appareil, ceci afin de montrer le maximum d'éléments sur la même figure.

La figure 2 représente en coupe l'extrémité d'un poinçon, selon un premier mode de réalisation.

La figure 3 représente en coupe l'extrémité d'un poinçon, selon un second mode de réalisation.

La figure 4 est une vue schématique en perspective d'un système de poinçonnage constitué de plusieurs appareils selon l'invention.

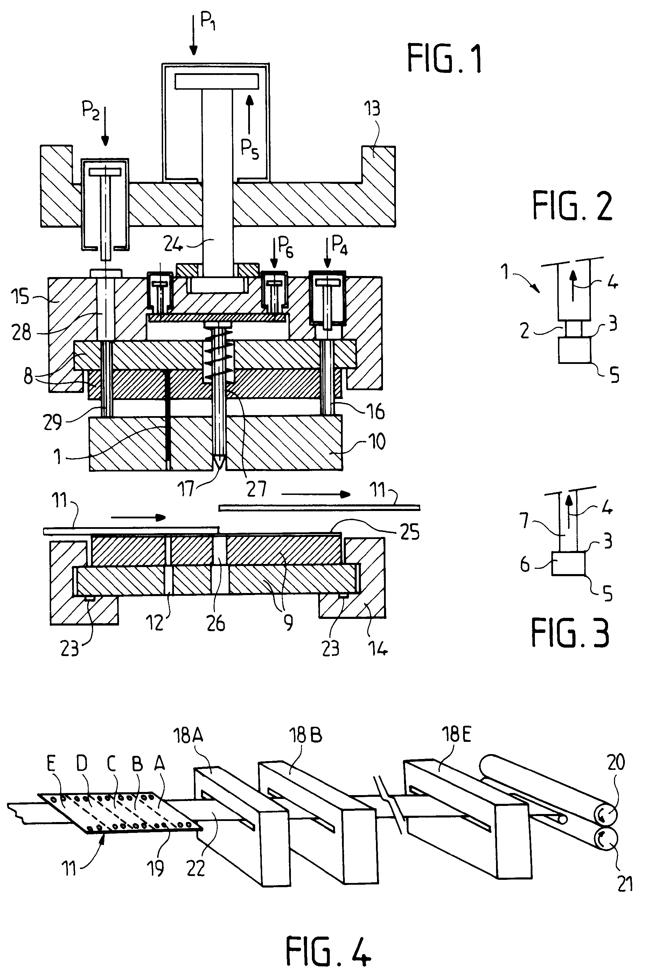

L'appareil représenté à la figure 1 comporte :
- un bâti en éléments vissés, soudés ou moulés dont seules deux parties fixes, 13 (en haut), et 14 (en bas), sont représentées très schématiquement.
- une partie d'outil supérieure qui peut glisser verticalement par rapport aux parties fixes. Cette partie d'outil supérieure comporte un support 15 qui pourrait être monté par exemple sur de classiques colonnes à billes et qui est solidaire du porte-poinçons 8, qui lui même supporte avec glissement vertical le serre-flanc 10. Le porte-poinçons est fait d'une partie inférieure porte-poinçons proprement dite dans laquelle sont placés des poinçons 1 (un seul d'entre eux est représenté), et d'une partie supérieure dite plaque de frappe. Le serre-flanc 10 est muni de trous (un seul d'entre eux est représenté) au travers desquels passent les poinçons 1 (un seul d'entre eux est représenté).
- une partie d'outil inférieure qui est la matrice portée par l'élément de bâti 14 au moyen d'un système à coussin d'air 23 lui laissant suffisamment de liberté pour qu elle se centre sur un pilotage. La matrice 9 est réalisée en deux parties, une partie supérieure qui est la matrice proprement dite et une partie inférieure porte-matrice qui repose sur le coussin d'air. Elle est percée de trous 12 (un seul d'entre eux est représenté) pour le passage des poinçons.

Bien entendu, la configuration et la forme des orifices à poinçonner est différente pour chaque type de circuit. Il existe plusieurs moyens connus pour obtenir une configuration déterminée des poinçons : on peut utiliser un ensemble de poinçons présents à chaque position d'une grille (par exemple au pas de 2,54 mm), en mettant en action seulement les poinçons correspondant à la configuration désirée soit avec des actionneurs (comme décrit par exemple dans IBM Disclosure Bulletin, Vol 26 N°10A March 1984, page 5100), soit au moyen d'une plaque modèle (comme décrit par exemple dans FR-A-2 248 666). On peut aussi, avec un support de poinçons permettant le montage d'un poinçon à chaque position d'une grille, ne monter de poinçons que dans les positions correspondant à la configuration désirée. En ce qui concerne le serre-flanc et la matrice, ils comportent de préférence un trou à chaque position d'une grille.

Le mouvement de montée/descente du porte-poinçons 8 par rapport à la matrice 9 est commandé par un vérin hydraulique central P1 (constituant lesdits premiers moyens commandables). Le serre-flanc 10 est commandé en descente par des vérins P2 (constituant les seconds moyens commandables) dont un seul est représenté, qui sont distincts et indépendants du vérin P1 qui commande le porte-poinçons 8. Ceci permet donc d'appliquer des forces indépendantes et parfaitement contrôlées sur le serre-flanc et sur le porte-poinçon.

Les vérins P2 appuient sur des pièces intermédiaires 28 en forme de clou (une seule est représentée) dont la tête appuie sur le support 15, et dont la tige traverse ce support 15 pour venir appuyer sur le porte-poinçons 8. Le serre-flanc 10 est muni de colonnes 29 (une seule est représentée) qui coulissent avec le moins de jeu possible dans le porte-poinçons 8. Ces colonnes débouchent à la partie supérieure du porte-poinçons en face de l'extrémité inférieure des pièces 28 et en fin de compte les vérins P2 appuient sur le serre-flanc par l'intermédiaire des pièces 28 et 29. Le support 15 et le porte-poinçons 8 descendent en même temps que le serre-flanc, mais ils peuvent aussi, sous l'action du vérin P1, descendre seuls en comblant le vide existant au départ entre les pièces 8 et 10.

Le serre-flanc 10 est en outre lié au porte-poinçons 8 par d'autres colonnes 16 (une seule est représentée) qui coulissent aussi dans le porte-poinçons, et sur lesquelles peut appuyer un ensemble de vérins P4 (constituant des troisièmes moyens commandables) dont un seul est représenté, pour écarter l'un de l'autre le porte-poinçons et le serre-flanc.

Les points d'application de la force des vérins P2 étant situés près des bords du serre-flanc, ce dernier est précontraint c'est-à-dire qu'il a, au repos, une forme convexe avec sa convexité tournée vers le circuit imprimé. Cette forme est destinée à compenser la déformation produite par l'effort de pression sur le circuit imprimé. De même, les points de fixation du porte-poinçons 8 sur son support 15 étant situés près des bords du porte-poinçons, ce dernier est précontraint c'est-à-dire qu'il a, au repos, une forme convexe avec sa convexité tournée vers le circuit imprimé. Bien entendu la convexité du porte-poinçons et celle du serre-flanc sont très faibles et ne sont pas visibles sur la figure.

Comme la matrice est ici portée par un coussin d'air 23 qui lui laisse une liberté dans le sens horizontal, pour que le serre-flanc et la matrice soient néanmoins positionnés avec précision, ils sont munis de moyens de positionnement relatif par rapport au circuit imprimé. Ces moyens sont ici des pions à extrémité conique 17 (il y en a deux : un de chaque coté de l'appareil) guidés latéralement du fait qu'ils passent avec aussi peu de jeu que possible dans des trous 27 du porte-poinçons et qui sont destinés à s'engager avec le moins de jeu possible dans des trous 26 de la matrice. Le circuit imprimé peut aussi être percé à l'avance de trous de centrage selon la même configuration, et ainsi il est positionné viv-à-vis des pièces de l'appareil par les mêmes pions, qui traversent d'abord les trous du circuit imprimé avant de pénétrer dans ceux de la matrice. Le pion 17 est actionné en descente par un ensemble de vérins P6.

On pourrait aussi imaginer de monter la partie d'outil supérieure sur un coussin d'air ou autre moyen laissant un jeu latéral, la matrice étant alors fixe. Avec la configuration de l'appareil représentée ici à titre d'exemple, cela serait assez complexe étant donné le grand nombre d'éléments mobiles qui constituent la partie d'outil supérieure, mais cela pourrait être valable avec une autre configuration.

L'appareil est muni de moyens (non représentés) de chauffage avec régulation en température de la matrice d'une part, et du serre-flanc d'autre part, qui peuvent par exemple être faits de résistances chauffantes électriques incorporées dans chacun de ces éléments, avec des sondes de mesure incorporées qui agissent sur un dispositif électrique connu de régulation de la puissance électrique appliquée aux résistances chauffantes. En plus des avantages déja mentionnés pour le chauffage, la régulation permet d'obtenir une température précise et en conséquence, une dilatation reproductible des plaques de circuit imprimé, et donc une meilleure précision.

Le cycle de fonctionnement de l'appareil est le suivant : dans une première phase d'amenée du circuit, le vérin central est en position haute symbolisée par P5, les autres vérins sont inactifs, et l'appareil est dans la position représentée. Une plaque de circuit imprimé est amenée, puis les moyens de manutention de la plaque sont escamotés. Dans la phase suivante a lieu la descente des moyens de pilotage, par actionnement des vérins P6 : le pion 7 descend par rapport à l'ensemble porte-poinçons/serre-flanc et dépasse en dessous du serre-flanc. Dans la phase suivante, l'ensemble porte-poinçons et serre-flanc descend en bloc sous l'effet des vérins P2, mais les poinçons ne dépassent toujours pas à l'extérieur du serre-flanc. L'outil vient donc en appui sur le circuit imprimé. Il entraine le piston du vérin central en refoulant l'huile de la chambre P5, et simultanément la chambre P1 se remplit sans exercer d'effort sur le piston, ou avec un effort faible (inférieur à l'effort de poinçonnage). Une pression déterminée est alors appliquée et le circuit imprimé 11 prend la température du serre-flanc et de la matrice entre lesquels il est serré. Ceci prend environ trois secondes. Dans la phase suivante a lieu le poinçonnage par action du vérin P1, les vérins P2 et P6 restant en pression. Dans la phase suivante a lieu le dévêtissage : la pression diminue dans les vérins P1 et P2, et une pression est établie dans le vérin P4 qui prend appui par l'intermédiaire des colonnes 16 sur le serre-flanc 10 pour faire remonter le support 15 et le porte-poinçons 8.

L'appareil est muni de moyens pour modifier la pression sur le serre-flanc, par exemple un automate connu (non représenté), programmé de façon adéquate pour diminuer la pression d'huile dans le vérin P2. Ceci permet de réaliser une détente du matériau du circuit imprimé, à la suite de quoi un deuxième cycle de poinçonnage est réalisé avec le même outil et sur la même plaque de circuit imprimé, en conservant la pression diminuée. Bien entendu, il convient de maintenir une pression minimale pour maintenir fixé le circuit imprimé.

Enfin la remontée de l'outil est réalisée : les pressions dans P6 et P4 sont supprimées ou inversées et une pression est établie dans l'actionneur commandable P5, pour appliquer une force sur le porte-poinçon dans la direction d'extraction des poinçons, ce qui ramène à nouveau l'appareil dans la position représentée sur le dessin, pour l'évacuation du circuit imprimé.

Les diamètres des trous 12 de la matrice sont assez grands pour permettre le passage des poinçons malgré des tolérances larges sur la position du porte-poinçon. Il est évident qu'un montage avec des tolérances larges est moins coûteux qu'un montage de haute précision. Pour éviter les inconvénients qui pourraient en résulter du point de vue de la précision géométrique des trous réalisés, la matrice est recouverte d'une tôle 25 dont les trous ont été percés par les poinçons de l'appareil eux mêmes : cette tôle est en acier très dur (par exemple un acier au silicium), et elle est mise en place non percée, après quoi on effectue un cycle de poinçonnage à vide, ce qui a pour effet de percer la tôle 25 avec une grande précision aux endroits voulus. Il est clair qu'il y a avantage à ce que la matrice comporte un trou à chaque position d'une grille universelle, les trous inutiles étant bouchés par la tôle. La matrice est donc un outil non interchangeable, alors que la tôle est changée à chaque fois qu'il s'agit de poinçonner un nouveau modèle de circuit.

L'extrémité du poinçon 1 qui est représentée sur la figure 2 est munie d'une arête d'extrémité tranchante 5 et comporte en outre une gorge 2 dont un bord 3 constitue une seconde arête tranchante qui est orientée en sens inverse de l'arête 5 de la susdite extrémité tranchante et qui est destinée à couper lors du mouvement du poinçon dans le sens indiqué par une flèche 4, c'est-à-dire au cours du mouvement de retrait du poinçon.

Selon une variante, l'extrémité du poinçon qui est représentée sur la figure 3 est munie également d'une arête d'extrémité tranchante 5 et comporte en outre deux tronçons 6 et 7 dont les diamètres sont différents, et un bord 3 du tronçon 6 dont le diamètre est le plus grand constitue une seconde arête tranchante qui est orientée en sens inverse de l'arête 5 de la susdite extrémité tranchante et qui est destinée à couper lors du mouvement du poinçon dans le sens indiqué par la flèche 4, c'est-à-dire au cours du mouvement de retrait du poinçon.

La force nécessaire pour poinçonner les trous les plus courants dans la technique des circuits imprimés est de l'ordre de 70 décanewton, et comme le nombre de trous d'un "quarto", c'est-à-dire d'une plaque de circuit imprimé d'un seul tenant, peut atteindre plusieurs centaines, cela conduit à des forces extrêmement élevées sur les pièces de l'appareil, de l'ordre de 50 kilonewton par décimètre carré de circuit imprimé, forces qui nuisent à la précision de l'appareil. Pour remédier à cet inconvénient, on a prévu un perçage des quartos en plusieurs fois. Par exemple on peut traiter des quartos de 508X404 mm et d'épaisseur 1,6 mm au moyen de cinq à sept passes successives. Si un quarto comporte une grande quantité de petits motifs répétitifs, il peut être traité en plusieurs fois sur le même appareil, en avançant à chaque fois de la valeur d'un ou plusieurs pas de répétition entre motifs.

Mais si au contraire la configuration de trous s'étend sans répétitivité sur tout le quarto, on doit s'y prendre autrement. Sur la figure 4 est représenté un quarto 11, sur lequel sont indiquées cinq zones A, B, C, D, E. Si l'on cherchait avant tout une économie dans l'investissement, on pourrait n'utiliser qu'un appareil. Celui-ci poinçonnerait d'abord la partie A. On passerait alors dans cet appareil toute une série de quartos à fabriquer, puis on modifierait l'appareil (position des poinçons et de la tôle 25) pour l'adapter au poinçonnage de la partie B, et on repasserait une deuxième fois dans l'appareil toute la série de quartos, et ainsi de suite pour les parties C, D, E.

Ceci pourrait convenir pour des petites séries de circuits, mais en pratique, pour obtenir des cadences plus importantes, le système préféré est celui de la figure 4 qui est constitué de plusieurs appareils 18A à 18E, chacun d'eux étant tel que décrit plus haut, et chacun d'eux poinçonnant une configuration de trous différente de celle des autres : l'appareil 18A poinçonne la partie A du circuit imprimé, l'appareil 18B poinçonne la partie B, et ainsi de suite.

Le système constitué de plusieurs appareils a en outre l'avantage que, dans le cas où deux trous sont trop proches l'un de l'autre pour permettre le montage de deux poinçons voisins sur un même support de poinçons, il est alors possible de réaliser ces deux trous l'un après l'autre dans deux appareils différents (qui alors traitent la même zone).

Les quartos peuvent être manutentionnés entre les appareils successifs par n'importe quel dispositif connu, ici par exemple un tapis roulant 22. Dans chaque appareil a lieu la sélection de la tranche à traiter et son centrage.

Le système peut être muni de moyens pour exercer une pression sur les circuits imprimés après le poinçonnage. Par exemple sur la figure 4 est représenté une sorte de laminoir constitué de deux rouleaux 20, 21 qui sont pressés l'un contre l'autre par un dispositif à ressort ou par des vérins hydrauliques (qui peuvent être réglés pour appliquer une force déterminée) et entre lesquels est forcé le passage des circuits imprimés.

Avec un système selon l'invention, il est possible de produire un quarto toute les dix à vingt secondes, alors qu'il faut environ quatre minutes en perçage par forets, et la qualité obtenue approche celle obtenue par perçage, et est suffisante dans la plupart des cas pour réaliser des circuits à double face et à trous métallisés.

## Revendications

1. Appareil de poinçonnage de circuits imprimés équipé d'une première partie d'outil à laquelle sont fixés une pièce porte-poinçons (8) et un serre-flanc (10), et d'une seconde partie d'outil constituée essentiellement d'une matrice, l'appareil étant prévu pour introduire entre le serre-flanc et la matrice une plaque de circuit imprimé (11) à poinçonner, appareil qui comporte des premiers moyens (P1) commandables pour appliquer une force sur le porte-poinçon dans la direction d'enfoncement des poinçons (1), et des deuxièmes moyens (P2) commandables indépendants des premiers pour appliquer une force sur le serre-flanc dans la direction qui appuie sur le circuit imprimé à poinçonner, caractérisé en ce que les premiers moyens comportent un actionneur commandable pour appliquer une force sur le porte-poinçon dans la direction d'extraction des poinçons, et en ce que des troisièmes moyens (P4) commandables sont prévus qui, prenant appui d'une part sur le porte-poinçons et d'autre part sur le serre-flanc, les écartent l'un de l'autre.

2. Appareil de poinçonnage de circuits imprimés selon la revendication 1, caractérise en ce qu'au moins une des deux parties d'outil est montée flottante, et le serre-flanc et la matrice sont munis de moyens de positionnement relatif l'un par rapport à l'autre et par rapport au circuit imprimé.

3. Appareil de poinçonnage de circuits imprimés selon l'une des revendications 1 ou 2, caractérisé en ce que, les points d'application de la force des deuxièmes moyens étant situés près des bords du serre-flanc, ce dernier est précontraint c'est-à-dire qu'il a, au repos, une forme convexe avec sa convexité tournée vers le circuit imprimé.

4. Appareil de poinçonnage de circuits imprimés selon l'une quelconque des revendications 1 à 3, caractérisé en ce que, les points d'application de la force des deuxièmes moyens étant situés près des bords du porte-poinçons, ce dernier est précontraint c'est-à-dire qu'il a, au repos, une forme convexe avec sa convexité tournée vers le circuit imprimé.

5. Appareil de poinçonnage de circuits imprimés selon l'une quelconque des revendications précédentes, caractérisé en ce qu'il est muni de moyens pour réaliser deux cycles de descente/remontée successifs des poinçons avec la même configuration de poinçonnage et sur une même plaque de circuit imprimé, et de moyens pour maintenir, tout en la modifiant entre les deux cycles, la force exercée par le deuxième moyen commandable.

6. Appareil de poinçonnage de circuits imprimés selon l'une quelconque des revendications précédentes, caractérisé en ce qu'il est muni de moyens de chauffage de la matrice et/ou du serre-flanc.

7. Appareil de poinçonnage de circuits imprimés selon l'une quelconque des revendications précédentes, caractérisé en ce que la matrice est recouverte d'une tôle dont les trous ont été poinçonnés par les poinçons de l'appareil eux mêmes.

8. Appareil de poinçonnage de circuits imprimés selon l'une quelconque des revendications précédentes, dont les poinçons sont munis d'une arête d'extrémité tranchante, caractérisé en ce que les poinçons sont munis d'une seconde arête tranchante qui est orientée en sens inverse de celle de la susdite extrémité tranchante et qui est destinée à couper au cours du mouvement de retrait du poinçon.

9. Appareil de poinçonnage de circuits imprimés selon la revendication 8, caractérisé en ce que ladite seconde arête tranchante est constituée du fait que le poinçon porte une gorge dont un bord constitue cette arête.

10. Système de poinçonnage de circuits imprimés, caractérisé en ce qu'il est constitué de plusieurs appareils (18A-18E) selon l'une quelconque des revendications précédentes, chacun d'eux poinçonnant une partie d'une plaque de circuit imprimé (11) avec une forme et/ou une configuration de trous différente de celle des autres appareils.

## Patentansprüche

1. Vorrichtung zum Stanzen von gedruckten Schaltungen mit einem ersten Werkzeugteil, an dem ein Lochdornhalterteil (8) und eine Andruckplatte (10) befestigt sind, und ein zweites Werkzeugteil, das im wesentlichen aus einer Matrize besteht, wobei die Vorrichtung dazu vorgesehen ist, zwischen die Andruckplatte und die Matrize eine zu stanzende Platine für eine gedruckte Schaltung (11) einzuführen, wobei die Vorrichtung erste steuerbare Mittel (P1) zur Ausübung einer Kraft auf den Lochdornhalter in die Absenkrichtung der Lochdorne (1) umfassen, sowie von den ersten Mitteln unabhängige zweite steuerbare Mittel (P2) zur Ausübung einer Kraft auf die Andruckplatte in die Richtung des Drucks auf die zu stanzende gedruckte Schaltung, dadurch gekennzeichnet, daß die ersten Mittel ein steuerbares Betätigungselement zur Ausübung eine Kraft auf den Lochdornhalter in Richtung des Herausziehens der Lochdorne umfaßt und dritte steuerbare Mittel (P4) vorgesehen sind, die einerseits auf dem Lochdornhalter und andererseits auf der Andruckplatte gelagert sind und diese beiden letzteren voneinander trennen.

2. Vorrichtung zum Stanzen von gedruckten Schaltungen nach Anspruch 1, dadurch gekennzeichnet, daß wenigstens eines der zwei Werkzeugteile beweglich montiert ist und die Andruckplatte und die Matrize mit Mitteln zur relativen Positionierung zueinander sowie zur gedruckten Schaltung versehen sind.

3. Vorrichtung zum Stanzen von gedruckten Schaltungen nach Anspruch 1 oder 2, dadurch gekennzeichnet, daß sich die Kraftangriffspunkte der zweiten Mittel in der Nähe der Ränder der Andruckplatte befinden, wobei letztere vorgespannt ist, das heißt, daß sie im Ruhezustand eine konvexe Form mit in Richtung der gedruckten Schaltung gewandter Ausbauchung hat.

4. Vorrichtung zum Stanzen von gedruckten Schaltungen nach einem der Ansprüche 1 bis 3, dadurch gekennzeichnet, daß sich die Kraftangriffspunkte der zweiten Mittel in der Nähe der Ränder des Lochdornhalters befinden, wobei letzterer vorgespannt ist, das heißt, daß er im Ruhezustand eine konvexe Form mit in Richtung der gedruckten Schaltung gewandter Ausbauchung hat.

5. Vorrichtung zum Stanzen von gedruckten Schaltungen nach einem der vorstehenden Ansprüche, dadurch gekennzeichnet, daß sie mit Mitteln zur Durchführung zweier aufeinanderfolgender Zyklen zum Heben/Senken der Lochdorne mit der gleichen Stanzkonfiguration und auf einer gleichen Platine für eine gedruckte Schaltung ausgestattet ist, sowie mit Mitteln zur Beibehaltung der vom zweiten steuerbaren Mittel ausgeübten Kraft, wobei die Kraft zwischen den zwei Zyklen verändert wird.

6. Vorrichtung zum Stanzen von gedruckten Schaltungen nach einem der vorstehenden Ansprüche, dadurch gekennzeichnet, daß sie mit Mitteln zur Beheizung der Matrize und/oder der Andruckplatte ausgestattet ist.

7. Vorrichtung zum Stanzen von gedruckten Schaltungen nach einem der vorstehenden Ansprüche, dadurch gekennzeichnet, daß die Matrize mit einem Blech abgedeckt ist, dessen Löcher von den Lochdornen der Vorrichtung selbst ausgestanzt worden sind.

8. Vorrichtung zum Stanzen von gedruckten Schaltungen nach einem der vorstehenden Ansprüche, wobei die Lochdorne der Vorrichtung mit einer Endschneidkante versehen sind, dadurch gekennzeichnet, daß die Lochdorne mit einer zweiten Schneidkante versehen sind, die in Gegenrichtung zu der Schneidkante des obengenannten Schneidendes ausgerichtet ist und dazu bestimmt ist, während der Rückziehbewegung des Lochdorns zu schneiden.

9. Vorrichtung zum Stanzen von gedruckten Schaltungen nach Anspruch 8, dadurch gekennzeichnet, daß die genannte zweite Schneidkante dadurch gebildet wird, daß der Lochdorn eine Auskehlung hat, von der ein Rand diese Schneidkante bildet.

10. System zum Stanzen von gedruckten Schaltungen, dadurch gekennzeichnet, daß es von mehreren Vorrichtungen (18A-18E) nach einem der vorstehenden Ansprüche gebildet wird, wobei jede von ihnen einen anderen Teil einer Platine für eine gedruckte Schaltung (11) mit einer Form und/oder Konfiguration von Löchern stanzt, die sich von der der anderen Vorrichtungen unterscheidet.

## Claims

1. A piercing device for printed circuits, comprising a first tool assembly to which are fixed a punch holder block (8) and a hold-down clamp (10), and a second tool assembly essentially formed by a die, the device being constructed to introduce a printed circuit board (11) to be pierced between the hold-down clamp and the die, the device comprising first controllable means (P1) for applying a force to the punch holder block in the direction of the stroke of the punches (1) and second controllable means (P2), which are independent of the first means, for applying a force to the hold-down clamp in the direction in which pressure is exerted on the printed circuit board to be punched, characterised in that the first means comprise a controllable actuator for applying a force to the punch holder block in the punch return direction, and in that third controllable means (P4) are provided which, by bearing upon the punch holder block on the one hand and upon the hold-down clamp on the other hand, separate them from one another.

2. A punching device for printed circuits as claimed in Claim 1, characterised in that at least one of the two tool assemblies is mounted to be floating, and the hold-down clamp and the die comprise means for positioning them relative to one another and relative to the printed circuit.

3. A punching device for printed circuits as claimed in Claim 1 or 2, characterised in that, since the points of application of the force of the second means are situated near the edges of the hold-down clamp, the latter is prestressed, *i.e.* in the rest state has a convex shape with its convexity facing towards the printed circuit.

4. A punching device for printed circuits as claimed in any one of the Claims 1 to 3, characterised in that, since the points of application of the force of the second means are situated near the edges of the punch holder block, the latter is prestressed, *i.e*. in the rest state has a convex shape with its convexity facing towards the printed circuit.

5. A punching device for printed circuits as claimed in any one of the preceding Claims, characterised in that it comprises means for effecting two successive down/up cycles of the punches with the same punching configuration and on the same printed circuit board, and means for maintaining the force exerted by the second controllable means while varying it between the two cycles.

6. A punching device for printed circuits as claimed in any one of the preceding Claims, characterised in that it comprises means for heating the die and/or the hold-down clamp.

7. A punching device for printed circuits as claimed in any one of the preceding Claims, characterised in that the die is covered by a metal sheet whose holes have been punched by the punches of the device themselves.

8. A punching device for printed circuits as claimed in any one of the preceding Claims, of which the punches have a rim with a cutting edge, characterised in that the punches have a second cutting edge which is oriented in the opposite direction to that of the first-mentioned cutting edge and which serves to effect cutting during the punch return movement.

9. A punching device for printed circuits as claimed in Claim 8, characterised in that said second cutting edge is formed in that the punch has a throat of which a rim constitutes this cutting edge.

10. A punching system for printed circuits, characterised in that it is formed by a plurality of devices (18A-18E) as claimed in any one of the preceding Claims, each of which punches one portion of a printed circuit board (11) with a shape and/or configuration of holes which differs from that of the other devices.
